# EUROPEAN PATENT SPECIFICATION

(11) **EP 2 684 218 B1**
(45) Date of publication and mention of the grant of the patent: **02.05.2018**
(21) Application number: 12754381.7
(22) Date of filing: 08.03.2012
(51) Int. Cl.: H01L 31/042, G01S 11/06, G01S 5/14, G01S 3/74

(54) **SELF MAPPING PHOTOVOLTAIC ARRAY SYSTEM**
SYSTEM MIT EINER SELBSTZUORDNENDEN PHOTOVOLTAIKZELLENANORDNUNG
SYSTÈME DE MATRICE PHOTOVOLTAÏQUE À CARTOGRAPHIE AUTOMATIQUE

(30) Priority: 09.03.2011 US 201161450877 P
(43) Date of publication of application: 15.01.2014
(73) Proprietor: Solantro Semiconductor Corp., Ottawa, Ontario K2E 7Y1 (CA)
(72) Inventor: COJOCARU, Christian, Ottawa, ON K2C 3R9 (CA); PAQUIN, Antoine, Navan, Ontario K4H 1H3 (CA)
(74) Representative: Smith, Jeremy Robert
(86) International application number: PCT/CA2012/000207
(87) International publication number: WO 2012/119233

(56) References cited:
- EP-A2- 2 081 045
- WO-A1-2008/144540
- WO-A2-2009/140551
- DE-A1-102009 029 934
- US-A1- 2003 232 598
- US-A1- 2006 267 833
- US-A1- 2010 238 862
- US-A1- 2010 241 375

## Description

### TECHNICAL FIELD

The present disclosure relates to photovoltaic array installations, and in particular to a photovoltaic array installation capable of generating a map of the location of photovoltaic panels.

### BACKGROUND

The use of photovoltaic (PV) panels, commonly referred to as solar panels is increasing. PV panels may be installed in an array or grid pattern. The PV panels of the installation may periodically require maintenance or replacement.

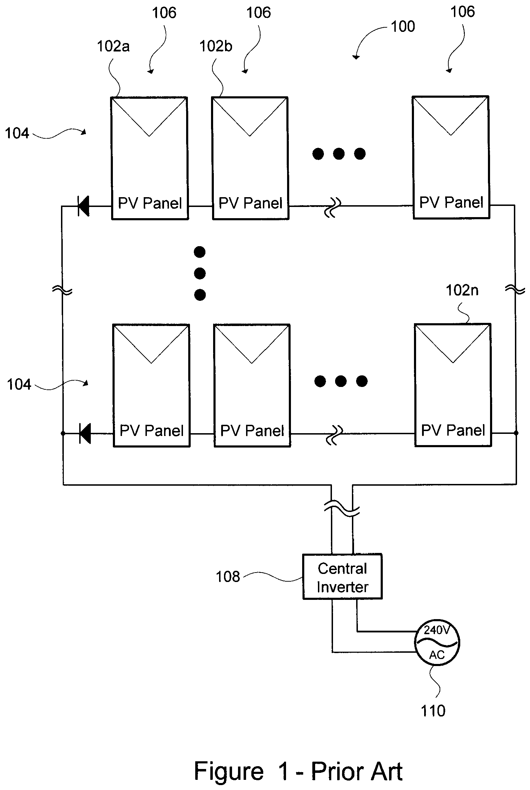

Figure 1 depicts in a block diagram an illustrative embodiment of prior art PV panel installation. The PV panel installation 100 comprises a plurality of individual PV panels 102a, 102b, 102n (referred to collectively as PV panels 102). The PV panels 102 can be arranged in an array comprising a plurality of columns 104 and rows 106. The panels in a row 104 may be connected together in series, and the rows in turn connected in parallel to a central inverter 108. The central inverter 108 receives the direct current (DC) power generated from the PV panels 102 and converts it to alternating current (AC) power that can be provided to an AC power distribution and transmission grid 110. The electrical current in a series branch of PV panels is forced to the lowest value set by the panel with the lowest illumination, for example due to local shading, therefore the central inverter cannot optimize the power generation parameters of each individual PV panel.

It is advantageous to integrate electronic power conversion functions in the individual PV panels in order to maximize the energy harvest for each panel. The electronic power conversion function can be a DC/DC converter or a DC/AC inverter. A PV panel with integrated electronics (referred to as an "integrated panel") has a lower reliability than a PV panel. Therefore, it is likely that an installation using integrated panels will require more maintenance of the panel array. In large installations, it may be difficult to locate a specific PV panel that requires maintenance or replacement. One possibility of addressing this problem is to periodically check each PV panel to determine if it is operating properly. Requiring the PV panels to be periodically checked regardless of if there is a problem or not wastes time and money as a maintenance worker is required to check all of the PV panels.

It would be desirable to have a PV panel installation capable of providing a location map of the PV panels of the installation.

DE102099029934 discloses a PV system in which a plurality of PV modules are connected together to form PV arrays. Each of the PV modules has a network interface to transmit module-specific data to a
controller to be evaluated. The data network is designed as a self-organizing network, in particular as a self-organizing meshed wireless network.

EP2081045 discloses a radio network system and method for determining an unknown position of a transmitting/receiving unit of a radio network involving measuring a signal field strength or duration of signals by the radio communication network. The signals are received by antennas where signal quality is determined by the radio communication network. The measured signal field strength or duration is assessed depending on the determined signal quality.

### SUMMARY

In an aspect there is provided a photovoltaic panel as defined in claim 1. In a further aspect there is provided a photovoltaic installation as defined in claim 9. In a further aspect there is provided a method of determining locations of photovoltaic (PV) panels in a PV panel installation as defined in claim 13.

### BRIEF DESCRIPTION OF THE DRAWINGS

Various embodiments of self mapping PV panel installation will be described with reference to the drawings, in which:
Figure 1 depicts in a block diagram a prior art PV panel installation;
Figure 2 depicts in a block diagram an illustrative embodiment of components of an integrated panel;
Figure 3 depicts in a block diagram an illustrative embodiment of components of a further integrated panel;
Figure 4 depicts an illustrative transmission pattern of a directional antenna;
Figure 5 depicts in a block diagram an illustrative embodiment of a self-mapping AC panel installation;
Figure 6 depicts transmitting and receiving locating signals using directional antennas
Figure 7 depicts in a flow chart a method of generating a location map for an AC panel installation;
Figure 8 depicts a further technique for determining locations of integrated panels according to an example;
Figure 9 depicts a central control unit for mapping locations of PV panels in installation according to an example;
Figure 10 depicts a method of determining locations of photovoltaic (PV) panels in an installation according to an example; and
Figure 11 depicts an illustrative PV panel installation.

### DETAILED DESCRIPTION

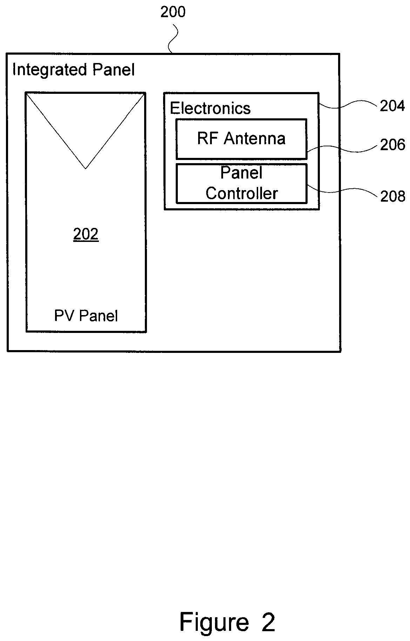

Figure 2 depicts in a block diagram an illustrative embodiment of components of an integrated panel. The integrated panel 200 may be used in a PV panel installation comprising an array of PV panels. The integrated panel 200 comprises a photovoltaic (PV) panel 202 and integrated electronics 204. The electronics may include an antenna 206 for transmitting and receiving radio frequency (RF) signals and a controller 208 for controlling the operation of the integrated panel 200 including generating locating signals for transmission, receiving locating signals transmitted by other PV panels and determining received signal strength indicator (RSSI) values of the received locating signals transmitted from other PV panels. The controller may also communicate the determined RSSI values of the received locating signals using the antenna. The RSSI value or values may be communicated to a central PV installation controller.

The RSSI value associated with RF signals received at a PV panel from other PV panels may be used in determining which PV panels are close to each other. The RSSI values information of locating signals received from other integrated panels can be communicated to the central PV installation controller and used to generate a location map of the integrated panel installation, indicating a location of individual integrated panels in the array. A central control unit may communicate with each of the individual integrated panels in order to control the overall location mapping. The communication between the PV panels and the central control unit may use the antenna for transmitting and/or receiving locating signals. Additionally or alternatively, the communication may use a separate antenna, such as an omni-directional antenna. If an omni-directional antenna is present, it may be used for receiving locating signals transmitted from other PV panels.

When the integrated panel comprises a DC/AC inverter the integrated panel may also be referred to as an AC panel. Connecting an inverter to a PV panel simplifies the installation of the AC panels, however the reliability of the AC panels may be lowered since the AC panel is more complex than the PV panel due to the extra electronics.

With AC panels, a certain percent of failed AC panels can be tolerated, for example 10%, before maintenance is required to repair or replace faulty AC panels. The PV installation continues to function at a reduced output power, as the failed AC panels do not affect the rest of the installation. This is in contrast to integrated panels that output DC power, since these integrated panels are typically installed with numerous panels connected in series, and so if one fails the entire series connection may not provide power. Regardless of whether the integrated panel outputs AC power or DC power, it may be necessary to locate a specific integrated panel in the PV installation in order to repair or replace components of an integrated panel.

Once the integrated panels are installed, the location of the integrated panels may be mapped by a central control unit. The central control unit may monitor one or more characteristics of the individual integrated panels, such as power produced, and if one of the integrated panels is determined to be operating below a nominal performance threshold, the central control unit can indicate the physical location of the integrated panel performing below the performance threshold, allowing a maintenance worker to more easily locate, fix and repair or replace the problem integrated panel.

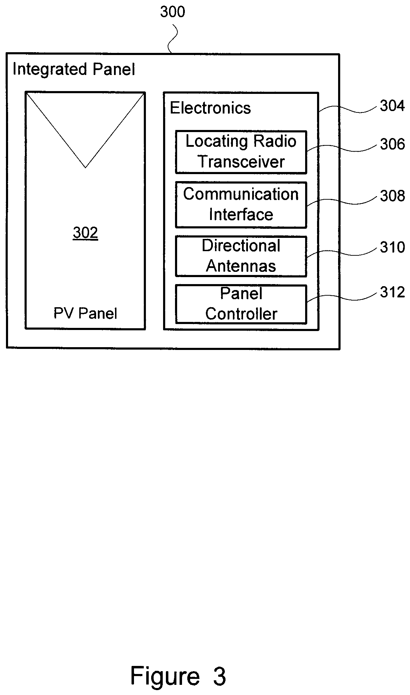

Figure 3 depicts in a block diagram an illustrative embodiment of components of an integrated panel. The integrated panel 300 comprises a PV panel 302 that generates DC power from light incident upon the face of the PV panel 302. The integrated panel 300 further comprises electronics 304. The electronics 304 may comprise various components including an inverter (not shown) for generating AC power from the DC power generated by the PV panel 302. The generated AC power may be used directly to power one or more devices requiring power, or may be provided to an AC transmission and distribution grid. Additionally or alternatively the electronics 304 may comprises a DC/DC converter (not shown). In addition to the power conversion components such as an inverter or a DC/DC converter, the electronics may further comprise a locating radio transceiver (LRT) 306 for generating a locating signal and determining a received signal strength indicator (RSSI) value for received locating signals, a communication interface 308 for communicating with a central control unit, a plurality of directional antennas 310 for transmitting and receiving locating signals, and a panel controller 312 for controlling the overall operation of the integrated panel 300.

The panel controller 312 may comprise, for example, a central processing unit (CPU), a microcontroller, a field programmable gate array (FPGA) or an application specific integrated circuit (ASIC). The panel controller 312 may control the operation of a DC/DC converter, a DC/AC inverter and/or other components of the integrated panel 300.

The communication interface 308 is used by the integrated panel 300 to provide two-way communication with a central control unit (not shown). The communication interface 308 may be provided by a wired connection or a wireless connection. For example, the wired connection may use power line communication. Additionally or alternatively, the communication interface may utilize wireless communication standards such as WiFi ™, WiMax ™, ZigBee™, Bluetooth™ or other wireless communications. The wireless communication interface may utilize a separate antenna from the directional antennas for transmitting and receiving the wireless communication signals. Additionally or alternatively still, the communication interface may utilize a mesh style communication between adjacent or close integrated panels using the one or more of the directional antennas 310. In this case, depending on the location of the panel in the array, a panel may communicate with the central control unit through multiple intermediary panels rather than directly.

The LRT 306 of the integrated panel generates a locating signal for transmission by one of the directional antennas 310 at a time. The LRT 306 also determines the RSSI value associated with a received locating signal transmitted from other integrated panels. Each of the directional antennas 310 are antennas that transmit an RF signal in one direction with a much higher signal strength, while the transmitted signal is greatly attenuated in the other directions.

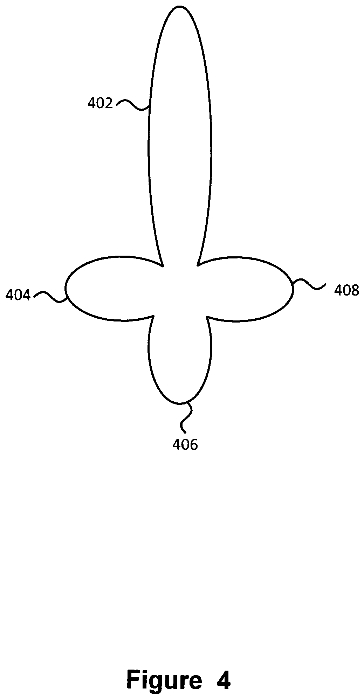

Figure4 depicts an illustrative transmission pattern of a directional antenna. As depicted, a directional antenna may transmit RF signals with a substantial portion of the radiated power along a transmission direction. A forward or main lobe 402 represents the most strongly transmitting direction of the antenna. The forward lobe 402 will have a rear lobe 406 arranged in the opposite direction that can transmit and/or receive signals with reduced gain in comparison the forward lobe 402. The receive characteristics of the antenna will have similar directionality, receiving most strongly signals in the direction of forward lobe 402. The side lobes 404, 408 may transmit and receive RF signals with equal efficiency.

Returning to Figure 3, each of the directional antennas 310 is arranged in a direction relative to the integrated panel 300, for example, a first directional antenna may have its transmission direction normal to a top of the integrated panel, while a second directional antenna may have its transmission direction normal to a side of the integrated panel. The panels are arranged so that the transmission directions of the individual directional antennas are at a relatively constant angle relative to the other directional antennas in the panel array. In one embodiment the transmission directions are oriented along the axes of the PV array. For example, in a rectilinear panel array arranged as rows and columns, if there are two directional antennas per panel, they may be arranged so their transmission directions are at 90 degrees relative to each other and transmitting along a vertical and a horizontal axis of the panel array.

The LRT 306 may control which of the directional antennas is to transmit the generated locating signal. The directional antennas may be coupled to the LRT 306 through respective RF switches. By closing the appropriate RF switch, it is possible to transmit or receive using one or more of the directional antennas 310.

The directional antennas 310 may also be used by each of the integrated panels in order to detect the locating signal transmitted by other integrated panels. Alternatively, if the panel communicates with the central controller using an omni-directional antenna, the locating signals may be detected using the omni-directional antenna. The LRT 306 determines the RSSI value when it receives a locating signal transmitted from other integrated panels. The signal might be detected by one or more of the panel's antennas to generate one or more RSSI values. For instance, the signal might be detected by one directional antenna, both directional antennas or both directional antenna and the omni-directional antenna. The integrated panel can communicate the RSSI value(s) to a central controller unit using the communication interface 308. As will be appreciated, the central controller is able to identify which panel the communicated RSSI values are received from.

The RF frequency used for mapping the locations of the integrated panels may be high, for example in the multi-gigahertz range, in order to have the directional antennas 210 small so that they can be printed on a printed circuit board (PCB). Locating signals transmitted using the directional antennas 210 are transmitted using low power so that they are localized over a short range of propagation. The frequency range used for transmission of the locating signals may be in the unlicensed Industrial, Scientific and Medical (ISM) bands of 2.4 GHz and/or 5.7 GHz, although other frequency ranges are also contemplated.

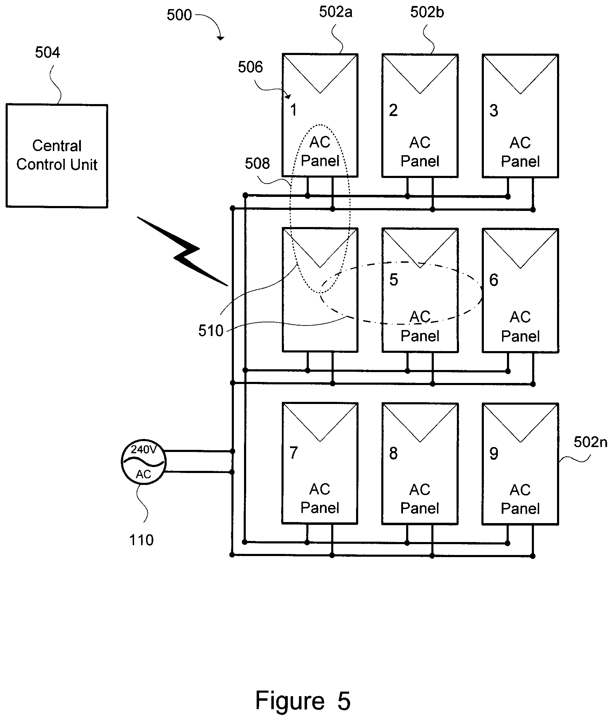

Figure 5 depicts in a block diagram an illustrative embodiment of a self-mapping AC panel installation that uses directional antennas. The AC panel installation 500 comprises a plurality of AC panels 502a, 502b, 502n (collectively referred to as AC panels 502) and a central control unit 504. Each of the AC panels 502 may be provided by an integrated panel 200 or 300 as described above and may include an AC inverter. Although described as an AC panel installation, the self-mapping described may be applied to other integrated panel installations. Each of the AC panels 502 comprises a unique identifier 506. It is noted that the unique identifier '4' is not depicted for the clarity of the Figure. As depicted, the AC panels 502 may communicate wirelessly with the central control unit 504, although it is contemplated that the AC panels 502 may communicate over a wired communication interface. The wireless communication may be provided by a separate omni-directional antenna that may also be used to receive the transmitted locating signals. Alternatively, the AC panels 502 may communicate with each other wirelessly using a mesh network and one or more of the AC panels may communicate with the central control unit 504, for example using a wired connection or a wireless communication method having a greater transmission distance.

When determining the RSSI values used to determine the location of the individual panels, each of the AC panels may operate in various different modes. A first mode may be used to communicate each of the unique identifiers 506 of the AC panels in the AC panel installation 500 to the central control unit 504. The first mode allows the unique identifiers of the AC panels in the installation to be discovered by the central controller. In a second mode, the AC panels 502 can transmit low-powered locating signals using the directional antennas. The central controller controls which of the AC panels is in the second mode so that only a single panel is transmitting a locating signal at a time. The transmitted locating signals are used for mapping the location of the AC panels 502 in the AC panel installation 500. In a third mode, the AC panels 502 may receive a transmitted locating signal using the directional antennas. Alternately AC panels may receive a transmitted locating signal using an omni-directional antenna associated with wireless communication with the central controller. Alternately AC panels may receive a transmitted locating signal using a combination of the directional and omni-directional antennas, which would each have an associated RSSI value. Once the control unit is aware of the individual AC panels, the control unit can communicate with each of the panels in order to control which mode the panel is operating in.

The central control unit 504 can perform a location mapping of the AC panels by first discovering all of the unique identifiers 506 of the individual AC panels 502. The AC panels 502 communicate their unique identifier back to the central control unit 504 at the command of the central control unit. Once all of the AC panels 502 have communicated their unique identifiers 506 to the central control unit 504, the central control unit 504 selects one of the AC panels 502 to transmit a locating signal, for example using one of the directional antennas of the selected AC panel. Other AC panels not transmitting the locating signal receive the transmitted locating signal and determine an associated RSSI value, or multiple RSSI values if the locating signal is received with multiple antennas, that the AC panels then communicate to the central control unit 504. Once the RSSI values are received, the central control unit 504 directs the selected AC panel to transmit the locating signal using another of the locating antennas. Other AC panels again receive the locating signal, determine an associated RSSI value or values and then communicate the RSSI values back to the central control unit 504. Once the RSSI values are received, the central control unit 504 selects another of the AC panels to transmit a locating signal. The central control unit 504 continues directing the AC panels to sequentially transmit locating signals and receives the RSSI values from the other AC panels until all of the AC panels have transmitted locating signals using at least two directional antennas, or until a sufficient amount of location information has been received in order to determine a PV installation map.

Each of the AC panels transmits a locating signal using at least two directional antennas. As depicted by broken lines 508, 510, which depict a main transmission direction of a directional antenna pair, the transmission pattern from the directional antennas concentrates radiated power in a specific direction, also referred to as the main lobe. Although described as transmitting in a particular direction it is noted that transmission occurs in all directions; however, the signal is greatly attenuated in directions other than the transmission direction of the directional antenna.

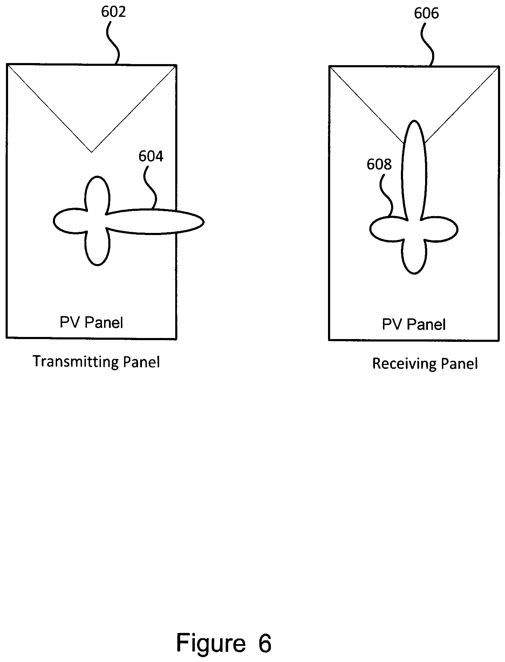

Figure 6 depicts transmitting and receiving locating signals using directional antennas. A locating signal transmitted from PV panel 602 may be transmitted using one of the directional antennas 604 and may be received at a PV panel 606 using the directional antenna 608 whose direction is normal to the direction of transmission. For instance, if the transmitting antenna is directed normal to a top of the integrated panel, the locating signal may be received by the antennas with direction normal to a side of the integrated panel. In this situation the receive characteristics of the receiving antenna are symmetric in the transmission direction and therefore do not bias the RSSI values. In this case the RSSI value for a locating signal received by an AC panel located in the direction of the transmitting antenna is larger than the RSSI value for a locating signal received by another AC panel located at equal distance but in a different direction than the direction of the transmitter. Furthermore, the RSSI value for a locating signal received by the AC panels will decrease the farther away the transmitting and receiving panels are. As such, it is possible to determine the closest AC panel in the transmission direction based on the RSSI value. Locating signals may also be received by an omni-directional antenna and also used to determine the closest AC panel in the transmission direction based on the RSSI value.

For each panel, the central control unit 504 causes the AC panel to transmit a locating signal in a first direction and receive the RSSI values from the other AC panels. The central control unit 504 then causes the AC panel to transmit a locating signal in a second direction and receives the RSSI values from the other AC panels. Based on the received RSSI values associated with each locating signal transmitted in the different directions, the central control unit 504 determines an adjacent AC panel in each of the transmission directions relative to the AC panel that transmitted the locating signal. Once all of the AC panels have transmitted locating signals, the central control unit can generate a location map from the determination of which panels are adjacent to each other. It is contemplated that the control unit may perform the location determination process multiple times in order to receive a plurality of readings and provide an average of the received signals.

The transmission direction of the locating antennas may be arranged to transmit towards a top and right of an AC panel. As depicted in Figure 5, not all of the AC panels will have an adjacent AC panel above it or to the right of it. The central control unit may utilize a detection threshold value for RSSI values, such that an RSSI value is only used to determine which AC panels are adjacent if it is above the threshold. The RSSI value received by the different AC panels when an AC panel in a top row is transmitting the locating signal may be below the RSSI threshold value, and as such the central control unit may determine that there are no other AC panels located to the top of the AC panel.

The locating signal transmitted by each AC panel using the directional antennas may be a continuous wave type signal that has no modulation and that provides a very narrow spectrum. It is possible that regulations require the power of the signal transmitted be below a particular value. Alternatively, the transmitted signal can be modulated for example using on-off keying (OOK), amplitude modulation or binary amplitude shift keying (AM or ASK) frequency modulation or binary frequency shift keying (FM or FSK). Modulating the locating signal may allow a data sequence to be sent in order to meet a "spectral mask" requirement for transmission. It is noted that although a data sequence may be modulated and transmitted by the locating signal, it is not necessary for the signal to be demodulated since only the strength of the received signal is required.

In addition to the distance between the transmitting and receiving panels, the RSSI value may be affected due to fading, which results from destructive interference between direct and reflected waves. Transmitting a modulated data sequence as opposed to a continuous wave may provide some resistance to fading affects since the modulated data sequence may have a wider frequency spectrum than the continuous wave. Fading is dependent upon the frequency of the transmitted signal. As such, it may be possible to reduce the effects of fading by transmitting a plurality of locating signals at different frequencies.

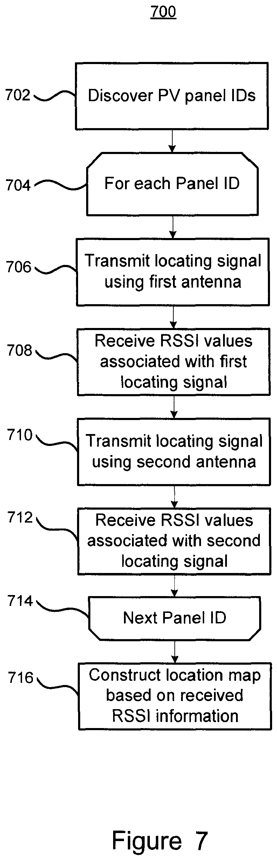

Figure 7 depicts in a flow chart a method of generating a location map for an AC panel installation. The method 700 begins by discovering the unique IDs of all of the AC panels (702). Each of the AC panels may transmit its unique ID to the central control unit using its communication interface. For each of the AC panels discovered (704), (714) the central control unit causes the AC panel to transmit a locating signal using one of the locating antennas, such as the 'top' antenna (706). Each of the AC panels, other than the AC panel transmitting the locating signal, receives the locating signal and transmits its RSSI value back to the central control unit. The central control unit receives the RSSI values from the AC panels (708). Depending on the size of the AC panel installation, not all of the AC panels may receive each locating signal. As such, the central control unit may wait to receive RSSI values for a period of time. After receiving the RSSI values, the central control unit causes the AC panel transmitting the locating signal to transmit the locating signal using the other locating antenna (710). The central control unit again receives RSSI values associated with the other locating signal (712). Once all of the AC panels have transmitted the locating signals, and the associated RSSI values from other AC panels, the central control unit constructs a location map of the AC panels (716) by determining, using the RSSI values, which AC panels are adjacent to each other.

Although the above described having each panel transmit locating signals, it is not necessary for every panel to transmit locating signals. A running record of located panels may be maintained during the transmission step. If every panel in the array has been located in both array directions then the transmission step may be terminated.

The location map constructed by the central control unit provides locations of AC panels relative to the other AC panels. However, additional information is required in order to provide a physical location of each AC panel. The additional information may be the physical location of one or more of the AC panels of the location map.

The location map constructed may be displayed on a graphical user interface to indicate a location of an AC panel that requires maintenance or replacement. Although not depicted in the figures, each of the AC panels may also be provided with a visual indicating means such as an LED that can be turned on by the central control unit to facilitate finding the AC panel that requires maintenance or replacement. A maintenance worker can be directed to the specific location of the AC panel and the visual indicating means may be used to verify the panel requiring maintenance or replacement.

An AC panel installation and AC panels have been described that allow the arrangement of the AC panels to be determined by transmitting locating signals using directional antennas. The locating map is generated by determining adjacent panels based on the strength of received locating signals along a transmission direction. Although the AC panel has been described as having two directional antennas arranged at 90 degrees to each other, it is possible to use additional directional antennas. It is also possible to use orientations other than 90 degrees. These might be preferable for non-rectilinear panel arrays such as on a triangular shaped roof section. Further, it is contemplated that a PV panel may comprise more than two directional antennas.

The method has been described as determining the adjacent AC panel based on the strongest RSSI value. RSSI values from additional AC panels may also be used when generating the location map. For example, lower RSSI values may be used as additional information when determining AC panel locations. The additional information may be useful to resolve discrepancies in the location map.

The integrated panels have been described as having either a wired or wireless communication interface for communicating with the control unit. If the integrated panels comprise a wireless interface, such as an IEEE 802.11 interface, for communicating with the central control unit, it may be possible to use the wireless interface to provide the RSSI values for panels. Although the wireless interface will typically not employ directional antennas, it may nonetheless be possible to provide sufficient location information to locate the individual panels. The RSSI values may be determined by repeatedly broadcasting a locating signal using increasing power. The received signal strength information received at other panels may provide an indication of which panels are located adjacent to the transmitting panel, although there will be no direction information, such as which panels are above or to the side. However, the RSSI values gathered from each panel transmitting signals of increasing strength may provide sufficient information to allow the central control unit to resolve the particular location of each integrated panel. It will be appreciated that the process for determining a location map using the wireless communication interface may be similar to that described above with respect to directional antennas. However, rather than transmitting signals first with one directional antenna and then the other, the control unit may control a transmitting panel to transmit at a first low power, and then again at an increased power. Conceptually, transmitting increasingly strong locating signals using an omni-directional antenna may provide information on which panels are located immediately adjacent the transmitting panel, followed by information on a further ring of panels and so on. The RSSI values collected at each panel during the transmission of locating signals from each of the other panels may be resolved at the central control unit to build a model of the PV installation and determine the location of the individual panels.

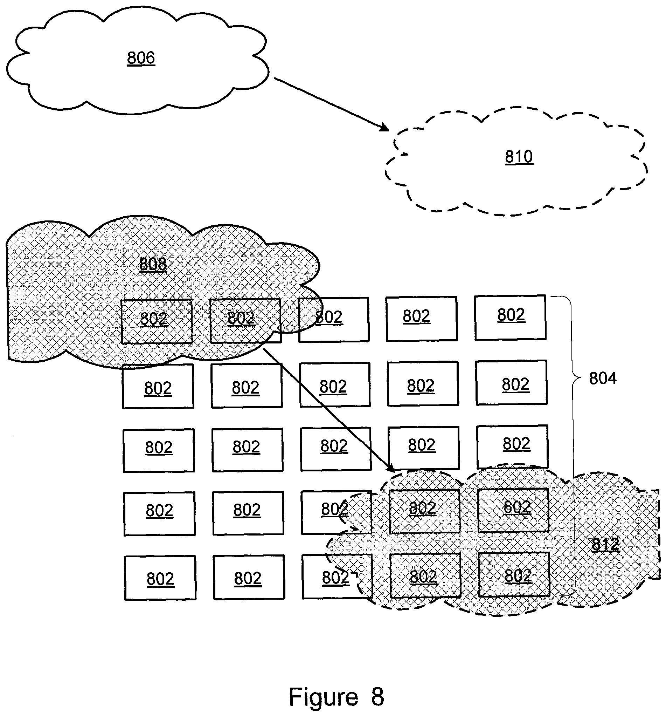

Figure 8 depicts a further technique for determining locations of integrated panels. The panels 802 are depicted as being aligned in a two dimensional array 804, although other arrangements are possible depending upon the installation. The location technique of Figure 8 involves detecting an obstruction as it moves across the panel array 804. As depicted, the obstruction may be a cloud 806 that is moving so that its shadow 808 passes over the panel array 804. It is contemplated that other obstructions may be used, such as a bird or airplane.

The power produced by a PV panel is dependent upon the amount of light incident upon the panel. When a shadow passes over the panel, the amount of incident light will decrease and so the power produced will also decrease. The PV panel may monitor the amount of power produced and provide an indication of the produced power to the central control unit. The central control unit receives the indication of the power produced from the plurality of PV panels and uses the information to determine the path of the obstruction's shadow as it passes over the array 804. In order to determine the path of the shadow, the power information must be associated with timing information in order to be able to identify when the shadow passed over a particular panel. Each PV panel may comprise an internal clock to track the time. Further, it is desirable to have the internal clocks of the PV panels synchronized to facilitate determining the shadow's path. The internal clocks may be synchronized by having a PV panel broadcast a synchronizing signal that is used to synchronize the internal clocks of the other integrated panels. Once the internal clocks of the PV panels are synchronized they may monitor the power produced at different times, and communicate the information back to the central control unit. The power information may be communicated to the central control unit as it is captured, or alternatively, the PV panel may temporarily store the information and communicate the information to the central control unit periodically, such as every hour, or day.

The central control unit processes the power information received from all of the panels to determine a location of each panel. Considering the depicted example, as the cloud passes from a first location 806 to a second location 810, the shadow moves across the panel from a first location 808 to a second location 812. The drop in power produced by panels will similarly drop. As such, the central control unit can process the power information to build a model of the panel array that matches the received power information.

Although a single obstruction passing over the array may not provide sufficient information to locate each panel; over time a plurality of obstructions will likely pass over the array thereby providing sufficient information to determine the location of each PV panel. For example, consider a shadow that passes horizontally across the panel array 804, the power information, namely the timing of the power drop of the panels, will be able to determine a horizontal order of the PV panels, but will be unable to determine a vertical order. However, if a second shadow passes vertically across the panel array 804, the power information can determine the vertical order of panels in the panel array, which can be combined with the horizontal ordering in order to determine a location of each of the panels in the installation. A single shadow or obstruction may only provide sufficient information to provide a partial ordering of panels. As more shadows or obstructions pass over the panel array, the central control unit can combine the information to provide a complete ordering of panels.

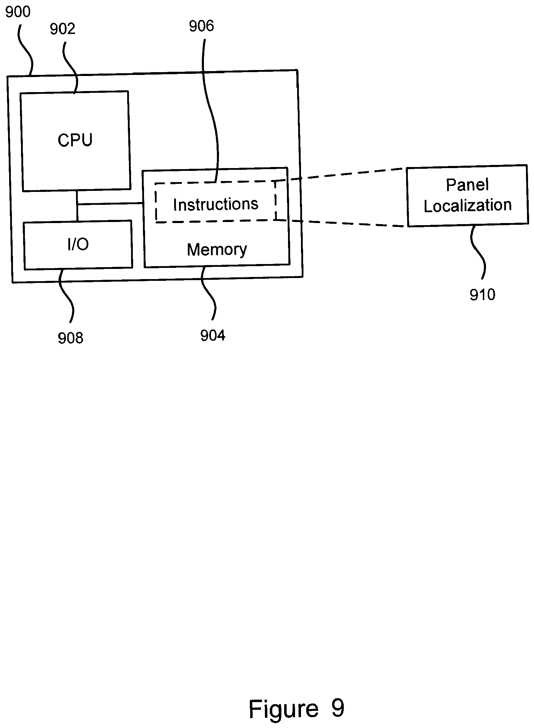

Figure 9 depicts a central control unit for mapping locations of PV panels in installation. The system 900 comprises a processor 902, which may be provided by a central processing unit (CPU), and memory 904 connected to the processor 902. The memory 904 may comprise random access memory (RAM) or other types of memory and may be provided separate from the processor 902, as part of the processor 902, or a combination thereof. The system 900 may further comprise non-volatile storage (not shown) for providing storage when the system 900 is powered off. The system 900 may further comprise an input/output (I/O) interface 908 for connecting other devices or components to the processor 902. For example, a display and keyboard may be connected to the system 900. Further, the I/O interface 908 may further connect a communication interface for communicating with the panels or other computers. The communication interface, or interfaces, may comprise a wired or wireless communication interface. The memory 904 stores instructions 906, that when executed by the processor configures the system to provide functionality 910 for mapping the location of the PV panels. The computer 900 may further provide monitoring and control functionality for the PV panel. For example, the computer 900 may provide functionality for displaying function characteristics of the PV panel installation.

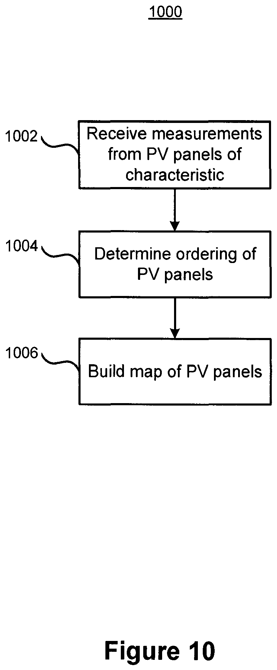

Figure 10 depicts a method of determining locations of photovoltaic (PV) panels in an installation. The method may be implemented at a central control unit that is in communication with each of the PV panels. The method 1000 receives measurements from a plurality of the PV panels of a characteristic (1002). The characteristic that is measured provides an indication of adjacent PV panels. As described above, the
characteristic may be a received signal strength of a locating signal, received using either a direction antenna or an omni-directional antenna. The characteristic may further comprise an indication of power produced by each panel at particular times. Although specific examples of characteristics that provide an indication of adjacent PV panels have been described, it is contemplated that other characteristics could be measured. After receiving measurements from the PV panels, the method determines an order of the PV panels (1004). The ordering is based on the indication of which panels are adjacent to each other as provided by the measurements of the characteristic. The ordering may be a partial ordering if the measured characteristic does not provide sufficient information to provide a complete ordering of the PV panels. As more measurements are received, the partial ordering may be resolved to a complete ordering. A map is built of the PV panels and their locations (1006). The map is built using the ordering information, which may only be a partial ordering of the PV panels. When the map is built from a complete ordering of PV panels, the map provides the location of each PV panel in the installation. If the map is built from a partial ordering of PV panels, it may provide an estimate of where PV panels are located in the installation. The map may be built by combining the ordering information, which provides a relative location of the PV panels to each other with specific location information, such as the physical arrangement of the installation, which could be provided as dimensions of an array, or the physical location of one or more PV panels within the installation. Once the map is built it may be used to aid in the operation and maintenance of the PV panel installation.

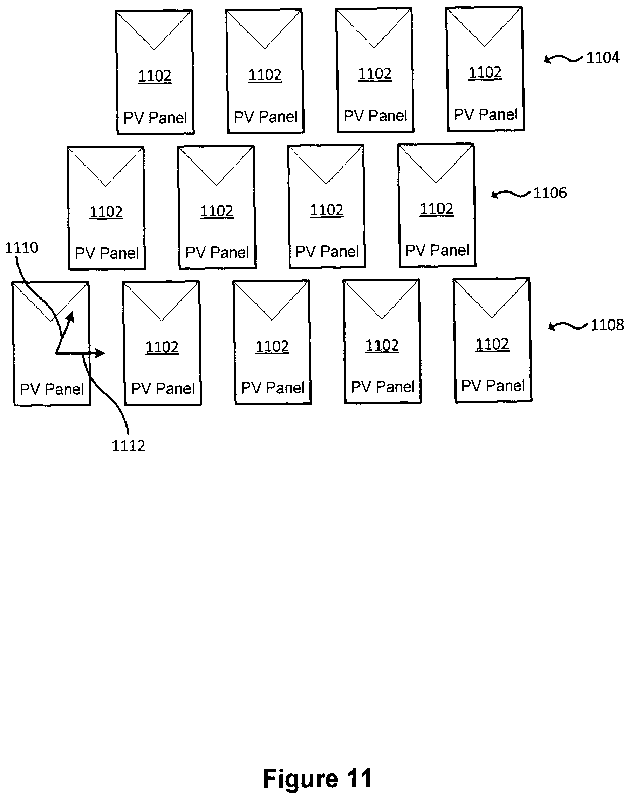

Figure 11 depicts a further illustrative PV panel installation. The above has described the PV panels being arranged in rows and columns. As depicted in Figure 11, the PV panel installation comprises a plurality of PV panels 1102 arranged in offset rows 1104, 1106, 1108. If the PV panels are arranged in a non-rectilinear installation, the directional antennas may be arranged based on the geometry of the installation. As depicted, the PV panels 1102 may have two directional antennas whose transmission directions 1110, 1112 are aligned with the geometry of the PV panel installation.

The following examples are not part of the claimed subject matter. In accordance with the present example there is provided a photovoltaic (PV) panel comprising an antenna for transmitting and receiving radio frequency (RF) signals; and a panel controller for generating
locating signals for transmission, receiving locating signals transmitted by other PV panels, determining received signal strength indicator (RSSI) values of received locating signals from other PV panels and communicating the RSSI values of the received locating signals using the antenna to a remote controller.

In accordance with the present example there is further provided a photovoltaic (PV) installation comprising: a plurality of PV panels and a central PV installation controller. Each of the PV panels comprises a PV panel for generating power from incident light; an antenna for transmitting and receiving radio frequency (RF) signals; and a panel controller for generating a locating signal for transmission by the antenna, receiving locating signals transmitted by other PV panels, determining received signal strength indicator (RSSI) values of received locating signals from other PV panels and communicating the RSSI values of the received locating signals using the antenna. The central PV installation controller for communicating with one or more of the plurality of PV panels to receive the RSSI values from the plurality of PV panels and generating a map of the PV installation providing locations of individual PV panels in the PV installation.

In accordance with the present example there is further provided a method of determining locations of photovoltaic (PV) panels in an installation. The method comprises receiving measurements from the PV panels of a characteristic providing an indication of adjacent panels in the installation; determining an ordering of the PV panels based on the measurements of the characteristics; and building a map of the locations of the PV panels based on the determined ordering of the PV panels.

In accordance with an example of the present disclosure there is provided a photovoltaic (PV) panel comprising: an antenna for transmitting and receiving radio frequency (RF) signals; and a panel controller for generating locating signals for transmission, receiving locating signals transmitted by other PV panels, determining received signal strength indicator (RSSI) values of received locating signals from other PV panels and communicating the RSSI values of the received locating signals using the antenna to a remote controller.

An example may further comprise a plurality of directional antennas, each having a main lobe in a respective transmission direction, the directional antennas for transmitting the locating signals substantially in the transmission directions.

In an example, the locating signals from other PV panels are received using the directional antennas.

In an example, the locating signals are received using side lobes of the directional antennas.

In an example, the locating signals are received by each of the directional antennas.

In an example, the antenna is an omni-directional antenna and receives locating signals from other PV panels.

In an example, the plurality of directional antennas comprise two directional antennas arranged with the respective transmission directions arranged orthogonally to each other.

In an example, the antenna is an omni-directional antenna and transmits and receives locating signals.

In an example, the transmitted locating signals are transmitted with varying power.

An example may further comprise an inverter module for converting the power produced by the PV panel into alternating current (AC) power, the inverter comprising the antenna and the controller.

In accordance with an example of the present disclosure there is provided a photovoltaic (PV) installation comprising: a plurality of PV panels, each comprising: a PV panel for generating power from incident light; an antenna for transmitting and receiving radio frequency (RF) signals; and a panel controller for generating a locating signal for transmission by the antenna, receiving locating signals transmitted by other PV panels, determining received signal strength indicator (RSSI) values of received locating signals from other PV panels and communicating the RSSI values of the received locating signals using the antenna; and a central PV installation controller for communicating with one or more of the plurality of PV panels to receive the RSSI values from the plurality of PV panels and generating a map of the PV installation providing locations of individual PV panels in the PV installation.

In an example, each of the plurality of PV panels comprise: a transmitting mode in which the respective PV panel transmits locating signals; and a receiving mode in which the respective PV panel receives locating signals from other PV panels and communicates location information to the central PV installation controller.

In an example, each of the PV panels further comprise a plurality of directional antennas, each having a main lobe in a respective transmission direction, the directional antennas for transmitting the locating signals substantially in transmission directions.

In an example, the central PV installation controller communicates with each of the plurality of PV panels to place one of the plurality of PV panels in the transmitting mode and to place the other PV panels in the receiving mode.

In an example, the central PV installation controller: a) sends a first command to one of the plurality of PV panels (the locating panel) to transmit a first locating signal using one of the plurality of directional antennas of the PV panel; b) receives a respective first one or more RSSI values from the plurality of PV panels, the first one or more RSSI values indicating a respective received strength of the first locating signal transmitted by the locating panel at respective PV panels; c) determines a first PV panel adjacent to the locating panel based on the received first plurality of RSSI values; d) sends a second command to the locating panel to transmit a second locating signal using another one of the plurality of directional antennas of the PV panel; e) receives a respective second one or more RSSI values from the plurality of PV panels, the second one or more RSSI values indicating a respective received strength of the second locating signal transmitted by the locating panel at respective PV panels; f) determines a second PV panel adjacent to the locating panel based on the received second plurality of RSSI values; and g) repeats (a) - (f) with a different PV panel acting as the locating panel.

In an example, the plurality of PV panels establish a mesh network for communicating location information to the central PV installation controller.

In accordance with an example of the present disclosure there is provided a method of determining locations of photovoltaic (PV) panels in an installation comprising: receiving measurements from the PV panels of a characteristic providing an indication of adjacent panels in the installation; determining an ordering of the PV panels based on the measurements of the characteristics; and building a map of the locations of the PV panels based on the determined ordering of the PV panels.

In an example, the characteristic comprises a measurement of the power produced at each of the PV panels.

In an example, the measurement of the power produced is associated with a time at which the measurement is made.

In an example, the measurement is further associated with a unique identifier of a respective PV panel.

In an example, determining the ordering is based on a time ordering of a decrease in the measured power produced by respective PV panels.

In an example, the characteristic comprises a received signal strength indication (RSSI) value of a locating signal transmitted by a PV panel.

In an example, the characteristic comprises a plurality of received signal strength indication (RSSI) values of a locating signal received with different antennas.

In an example, the locating signal transmitted by the PV panel is received using an omni-directional antenna.

In an example, the locating signal transmitted by the PV panel is transmitted at increasing strengths to provide an indication of adjacent PV panels.

In an example, the locating signal transmitted by the PV panel is received using a directional antenna.

In an example, determining the ordering comprises determining adjacent PV panels based on the RSSI values received from the directional antennas.

In an example, determining the ordering comprises: a) sending a first command to one of the PV panels (the locating panel) in the PV panel installation to transmit a first locating signal using one of a plurality of directional antennas of the PV panel; b) receiving a respective first plurality of RSSI values from a plurality of PV panels in the PV panel installation, the first plurality of RSSI values indicating a respective received strength of the first locating signal transmitted by the locating panel at respective PV panels; c) determining a first PV panel adjacent to the locating panel based on the received first plurality of RSSI values; d) sending a second command to the locating panel to transmit a second locating signal using one of a plurality of directional antennas of the PV panel; e) receiving a respective second plurality of RSSI values from a plurality of PV panels in the PV panel installation, the second plurality of RSSI values indicating a respective received strength of the second locating signal transmitted by the locating panel at each of the plurality of PV panels; f) determining a second PV panel adjacent to the locating panel based on the received second plurality of RSSI values; and g) repeating (a) - (f) with a different PV panel acting as the locating panel.

A PV panel installation may comprise a plurality of PV panels. In solar farm applications the panels may be arranged in an array of a plurality of regularly spaced rows and columns. Depending on the local geography the array may be rectangular in shape or irregularly shaped to correspond to geographic elements such as shorelines, property lines, roads or buildings. Depending on the local topography, the panels may be predominantly all in the same horizontal plane in the case of very flat terrain, in a different plane in the case of a hillside installation or in no particular plane in the case of undulating topography.

In Building Integrated Photovoltaic (BIPV) applications the panels will be arranged to conform to the building surfaces such as its roof or sides. In the case of a pitched roof the panels will typically be placed in the plane of the roof. In the case of a flat roof the panels may be tilted at an angle to the roof to maximize the amount of solar radiation captured by the panel. Depending on the roof style the panels may be arranged in rectangular arrays, triangular arrays or irregular shaped ones. Depending on the orientation of the building, panels may be arranged on multiple roof surfaces (e.g. east and west facing sides) or only one roof surface (e.g. southern facing side). Similar considerations apply to placement of panels on the sides of a building. Panel spacing may not always be constant. In the case of roof mounted structures such as roof vents, sanitary vents or dish antenna it may be beneficial to alter the panel spacing to prevent shadowing of the panel by these structures.

Each of the PV panels may comprise an attached DC/AC inverter or other power conversion electronics such as a DC/DC converter. PV panels with an attached inverter or other electronics may be referred to as an AC panel or integrated panel. Since the number of components in an integrated panel is greater than a simple PV panel, the likelihood of failure of a component is increased. If a component of the integrated panel fails, it may be necessary to locate the specific panel within the array to replace or repair the faulty component. However, it may be difficult to determine the particular location of the faulty integrated panel within the array.

As described further herein, the electronics included in the integrated panel may be used to communicate location information of the integrated panel back to a central location that may then determine the location of each integrated panel within the installation array. When an integrated panel fails, or its performance decreases, the location of the faulty panel can be provided to a maintenance worker, enabling the panel to be quickly located and repaired or replaced.

Various techniques may be used to locate individual integrated panels within the installation array. In broad terms, the techniques determine information that can be used in locating each panel relative to the other panels. That is, the techniques may not provide an absolute location of each panel, but rather may indicate which panels are located adjacent to other panels. This location information may then be combined with specific location information, such as the arrangement of the installation array or an absolute position of one or more panels, allowing the specific locations of individual panels to be determined within the array.

If the location information is used primarily to locate faulty panels for repair or replacement and if it is assumed that the panels will not fail in the short term after installation, then the techniques used to determine the location of panels may converge upon the panel locations slowly. For example, the panels could collect location information over a period such as a day, week, month or months, which may then be used to determine the panel locations.

The individual panels may collect or monitor various characteristics for the location information used in determining a map of the panel locations in the array. For example, the integrated panels may determine a received signal strength indication (RSSI) of the strength of radio frequency (RF) signals. Additionally or alternatively, the integrated panels may monitor characteristics of the PV panel, such as power produced by the PV panel, which may be used in tracking an obstruction, such as a cloud, as it moves across the panel installation.

## Claims

1. A photovoltaic (PV) panel (202, 302) comprising:
an antenna (310) for transmitting and receiving radio frequency (RF) signals; and
a panel controller (312) for generating locating signals for transmission under control of a remote controller, receiving locating signals transmitted by other PV panels, determining received signal strength indicator (RSSI) values of received locating signals from other PV panels and communicating the RSSI values of the received locating signals to the remote controller; further comprising a plurality of directional antennas each having a main lobe (402) in a respective transmission direction, the directional antennas for transmitting the locating signals substantially in the transmission directions.

2. The PV panel of claim i, wherein the locating signals from other PV panels are received using the directional antennas (310).

3. The PV panel of claim 2, wherein the locating signals are received by each of the directional antennas (310).

4. The PV panel of any one of claims 1 to 3, comprising an omni-directional antenna arranged to receive locating signals from other PV panels.

5. The PV-panel of any one of claims 1 to 4, wherein the plurality of directional antennas (310) comprise two directional antennas (508, 510) arranged with the respective transmission directions arranged orthogonally to each other.

6. The PV-panel of any one of claims 1 to 5, further comprising at least one of:
an inverter module for converting the power produced by the PV panel into alternating current (AC) power, the inverter comprising the antenna and the controller; and
a DC-to-DC converter for outputting the power produced by the PV panel.

7. The PV-panel of any preceding claim wherein when transmitted, location signals are modulated.

8. The PV-panel of any preceding claim wherein when transmitted, location signals are transmitted at different frequencies.

9. A photovoltaic (PV) installation comprising:
a plurality of PV panels (202, 302) according to any one of claims 1 to 9; and
a central PV installation controller for communicating with one or more of the plurality of PV panels to control transmission of locating signals by each of the PV panels and to receive the RSSI values from the plurality of PV panels, the central PV installation controller further for generating a map of the PV installation providing locations of individual PV panels in the PV installation.

10. The PV installation of claim 9, wherein each of the plurality of PV panels (202, 302) comprise:
a transmitting mode in which the respective PV panel transmits locating signals; and
a receiving mode in which the respective PV panel receives locating signals from other PV panels and communicates location information to the central PV installation controller.

11. The PV installation of claim 9 or 10, wherein the central PV installation controller:
a) sends a first command to one of the plurality of PV panels (the locating panel) to transmit a first locating signal using one of the plurality of directional antennas of the PV panel;
b) receives a respective first one or more RSSI values from the plurality of PV panels, the first one or more RSSI values indicating a respective received strength of the first locating signal transmitted by the locating panel at respective PV panels;
c) determines a first PV panel adjacent to the locating panel based on the received first plurality of RSSI values;
d) sends a second command to the locating panel to transmit a second locating signal using another one of the plurality of directional antennas of the PV panel;
e) receives a respective second one or more RSSI values from the plurality of PV panels, the second one or more RSSI values indicating a respective received strength of the second locating signal transmitted by the locating panel at respective PV panels;
f) determines a second PV panel adjacent to the locating panel based on the received second plurality of RSSI values; and
g) repeats (a) - (f) with a different PV panel acting as the locating panel.

12. The PV installation of any one of claims 9 to 11, wherein the plurality of PV panels (202, 302) establish a mesh network for communicating location information to the central PV installation controller.

13. A method of determining locations of photovoltaic (PV) panels (202, 302) in a PV panel installation according to any one of claims 9 to 12, the method comprising:
receiving measurements from the PV panels of a characteristic providing an indication of adjacent panels in the installation;
determining an ordering of the PV panels based on the measurements of the characteristics; and
building a map of the locations of the PV panels based on the determined ordering of the PV panels.

## Patentansprüche

1. Photovoltaische (PV) Tafel (202, 302), umfassend:
eine Antenne (310) zum Übertragen und Empfangen von Funkfrequenz- bzw. RF-Signalen; und
eine Tafelsteuerung (312) zum Erzeugen von Lokalisierungssignalen zur Übertragung unter der Steuerung einer entfernten Steuerung, Empfangen von durch andere PV-Tafeln übertragenen Lokalisierungssignalen, Bestimmen von Werten zur Angabe der empfangenen Signalstärke (RSSI) von empfangenen Lokalisierungssignalen von anderen PV-Tafeln und Kommunizieren der RSSI-Werte der empfangenen Lokalisierungssignale an die entfernte Steuerung; ferner umfassend eine Vielzahl von Richtantennen, die jeweils eine Hauptkeule (402) in einer jeweiligen Übertragungsrichtung aufweisen, wobei die Richtantennen zum Übertragen der Lokalisierungssignale im Wesentlichen in den Übertragungsrichtungen dienen.

2. PV-Tafel nach Anspruch 1, wobei die Lokalisierungssignale von anderen PV-Tafeln unter Verwendung der Richtantennen (310) empfangen werden.

3. PV-Tafel nach Anspruch 2, wobei die Lokalisierungssignale durch jede der Richtantennen (310) empfangen werden.

4. PV-Tafel nach einem der Ansprüche 1 bis 3, umfassend eine ungerichtete Antenne, angeordnet zum Empfangen von Lokalisierungssignalen von anderen PV-Tafeln.

5. PV-Tafel nach einem der Ansprüche 1 bis 4, wobei die Vielzahl von Richtantennen (310) zwei Richtantennen (508, 510) umfasst, die mit den jeweiligen Übertragungsrichtungen senkrecht zueinander angeordnet sind.

6. PV-Tafel nach einem der Ansprüche 1 bis 5, ferner mindestens eines von Folgendem umfassend:
ein Wechselrichtermodul zum Umwandeln der durch die PV-Tafel erzeugten Leistung in Wechselstrom- bzw. AC-Leistung, wobei der Wechselrichter die Antenne und die Steuerung umfasst; und
einen Gleichstrom-zu-Gleichstrom-Wandler zum Ausgeben der durch die PV-Tafel erzeugten Leistung.

7. PV-Tafel nach einem der vorstehenden Ansprüche, wobei Lokalisierungssignale, wenn sie übertragen werden, moduliert werden.

8. PV-Tafel nach einem der vorstehenden Ansprüche, wobei Lokalisierungssignale, wenn sie übertragen werden, bei verschiedenen Frequenzen übertragen werden.

9. Photovoltaische (PV) Installation, umfassend:
eine Vielzahl von PV-Tafeln (202, 302) nach einem der Ansprüche 1 bis 9; und
eine zentrale PV-Installationssteuerung zum Kommunizieren mit einer oder mehreren der Vielzahl von PV-Tafeln zum Steuern der Übertragung von Lokalisierungssignalen durch jede der PV-Tafeln und zum Empfangen der RSSI-Werte von der Vielzahl von PV-Tafeln, die zentrale PV-Installationssteuerung ferner zum Erzeugen einer Karte der PV-Installation, die Orte von einzelnen PV-Tafeln in der PV-Installation bereitstellt.

10. PV-Installation nach Anspruch 9, wobei jede der Vielzahl von PV-Tafeln (202, 302) umfasst:
einen Übertragungsmodus, in dem die jeweilige PV-Tafel Lokalisierungssignale überträgt; und
einen Empfangsmodus, in dem die jeweilige PV-Tafel Lokalisierungssignale von anderen PV-Tafeln empfängt und Ortsinformationen an die zentrale PV-Installationssteuerung kommuniziert.

11. PV-Installation nach Anspruch 9 oder 10, wobei die zentrale PV-Installationssteuerung:
a) einen ersten Befehl an eine der Vielzahl von PV-Tafeln (die lokalisierende Tafel) sendet, um ein erstes Lokalisierungssignal unter Verwendung einer der Vielzahl von Richtantennen der PV-Tafel zu übertragen;
b) einen jeweiligen ersten einen oder mehrere RSSI-Werte von der Vielzahl von PV-Tafeln empfängt, wobei der erste eine oder die mehreren RSSI-Werte eine jeweilige empfangene Stärke des ersten Lokalisierungssignals angeben, übertragen durch die lokalisierende Tafel an jeweilige PV-Tafeln;
c) eine erste PV-Tafel angrenzend an die lokalisierende Tafel basierend auf der empfangenen ersten Vielzahl von RSSI-Werten bestimmt;
d) einen zweiten Befehl an die lokalisierende Tafel sendet, um ein zweites Lokalisierungssignal unter Verwendung einer anderen einen der Vielzahl von Richtantennen der PV-Tafel zu übertragen;
e) einen jeweiligen zweiten einen oder zweite mehrere RSSI-Werte von der Vielzahl von PV-Tafeln empfängt, wobei der zweite eine oder die zweiten mehreren RSSI-Werte eine jeweilige empfangene Stärke des zweiten Lokalisierungssignals angibt, übertragen durch die lokalisierende Tafel an jeweilige PV-Tafeln;
f) eine zweite PV-Tafel angrenzend an die lokalisierende Tafel basierend auf der empfangenen zweiten Vielzahl von RSSI-Werten bestimmt; und
g) (a) - (f) wiederholt, wobei eine verschiedene PV-Tafel als die lokalisierende Tafel fungiert.

12. PV-Installation nach einem der Ansprüche 9 bis 11, wobei die Vielzahl von PV-Tafeln (202, 302) ein Maschennetz zum Kommunizieren von Ortsinformationen an die zentrale PV-Installationssteuerung herstellt.

13. Verfahren zum Bestimmen von Orten von photovoltaischen (PV) Tafeln (202, 302) in einer Installation von PV-Tafeln nach einem der Ansprüche 9 bis 12, das Verfahren umfassend:
Empfangen von Messungen eines Charakteristikums, das eine Angabe von angrenzenden Tafeln in der Installation bereitstellt, von den PV-Tafeln;
Bestimmen einer Ordnung der PV-Tafeln basierend auf den Messungen des Charakteristikums; und
Erstellen einer Karte der Orte der PV-Tafeln basierend auf der bestimmten Ordnung der PV-Tafeln.

## Revendications

1. Panneau photovoltaïque (PV) (202, 302), comprenant :
une antenne (310) destinée à émettre et à recevoir des signaux radiofréquence (RF) ; et
une unité de commande (312) de panneau destinée à générer des signaux de localisation à émettre sous la commande d'une unité de commande à distance, recevoir des signaux de localisation émis par d'autres panneaux PV, déterminer des valeurs d'indicateur de puissance de signal reçu (RSSI) de signaux de localisation reçus en provenance d'autres panneaux PV et communiquer les valeurs de RSSI des signaux de localisation reçus à l'unité de commande à distance ; comprenant en outre une pluralité d'antennes directionnelles présentant chacune un lobe principal (402) dans une direction d'émission respective, les antennes directionnelles étant destinées à émettre les signaux de localisation sensiblement dans les directions d'émission.

2. Panneau PV selon la revendication 1, dans lequel les signaux de localisation en provenance d'autres panneaux PV sont reçus au moyen des antennes directionnelles (310).

3. Panneau PV selon la revendication 2, dans lequel les signaux de localisation sont reçus par chacune des antennes directionnelles (310).

4. Panneau PV selon l'une quelconque des revendications 1 à 3, comprenant une antenne omnidirectionnelle agencée pour recevoir des signaux de localisation en provenance d'autres panneaux PV.

5. Panneau PV selon l'une quelconque des revendications 1 à 4, dans lequel la pluralité d'antennes directionnelles (310) comprend deux antennes directionnelles (508, 510) agencées avec les directions d'émissions respectives agencées orthogonalement l'une à l'autre.

6. Panneau PV selon l'une quelconque des revendications 1 à 5, comprenant en outre :
un module onduleur destiné à convertir la puissance produite par le panneau PV en une puissance en courant alternatif (AC), l'onduleur comprenant l'antenne et l'unité de commande ; et/ou
un convertisseur continu-continu destiné à fournir la puissance produite par le panneau PV.

7. Panneau PV selon l'une quelconque des revendications précédentes, dans lequel les signaux d'emplacement qui sont émis sont modulés.

8. Panneau PV selon l'une quelconque des revendications précédentes, dans lequel les signaux d'emplacement qui sont émis sont émis à des fréquences différentes.

9. Installation photovoltaïque (PV), comprenant :
une pluralité de panneaux PV (202, 302) selon l'une quelconque des revendications 1 à 9 ; et
une unité centrale de commande d'installation PV destinée à communiquer avec un ou plusieurs de la pluralité de panneaux PV dans le but de commander l'émission de signaux de localisation par chacun des panneaux PV et de recevoir les valeurs de RSSI en provenance de la pluralité de panneaux PV, l'unité centrale de commande d'installation PV étant destinée en outre à générer une carte de l'installation PV fournissant des emplacements de panneaux PV individuels dans l'installation PV.

10. Installation PV selon la revendication 9, dans laquelle chacun de la pluralité de panneaux PV (202, 302) comprend :
un mode émission dans lequel le panneau PV respectif émet des signaux de localisation ; et
un mode réception dans lequel le panneau PV respectif reçoit des signaux de localisation en provenance d'autres panneaux PV et communique des informations d'emplacement à l'unité centrale de commande d'installation PV.

11. Installation PV selon la revendication 9 ou 10, dans laquelle l'unité centrale de commande d'installation PV :
a) envoie un premier ordre à l'un de la pluralité de panneaux PV (le panneau de localisation) d'émettre un premier signal de localisation au moyen d'une de la pluralité d'antennes directionnelles du panneau PV ;
b) reçoit une ou plusieurs premières valeurs de RSSI respectives en provenance de la pluralité de panneaux PV, la ou les premières valeurs de RSSI indiquant une puissance reçue respective du premier signal de localisation émis par le panneau de localisation au niveau de panneaux PV respectifs ;
c) détermine un premier panneau PV adjacent au panneau de localisation en fonction de la première pluralité de valeurs de RSSI reçues ;
d) envoie un deuxième ordre au panneau de localisation d'émettre un deuxième signal de localisation au moyen d'une autre de la pluralité d'antennes directionnelles du panneau PV ;
e) reçoit une ou plusieurs deuxièmes valeurs de RSSI respectives en provenance de la pluralité de panneaux PV, la ou les deuxièmes valeurs de RSSI indiquant une puissance reçue respective du deuxième signal de localisation émis par le panneau de localisation au niveau de panneaux PV respectifs ;
f) détermine un deuxième panneau PV adjacent au panneau de localisation en fonction de la deuxième pluralité de valeurs de RSSI reçues ; et
g) répète (a) - (f) avec un panneau PV différent jouant le rôle du panneau de localisation.

12. Installation PV selon l'une quelconque des revendications 9 à 11, dans laquelle la pluralité de panneaux PV (202, 302) établit un réseau maillé destiné à communiquer des informations d'emplacement à l'unité centrale de commande d'installation PV.

13. Procédé de détermination d'emplacements de panneaux photovoltaïques (PV) (202, 302) dans une installation de panneaux PV selon l'une quelconque des revendications 9 à 12, le procédé comprenant les étapes suivantes :
réception, en provenance des panneaux PV, de mesures d'une caractéristique fournissant une indication de panneaux adjacents dans l'installation ;
détermination d'un ordonnancement des panneaux PV en fonction des mesures des caractéristiques ; et
élaboration d'une carte des emplacements des panneaux PV en fonction de l'ordonnancement déterminé des panneaux PV.
